# EUROPEAN PATENT APPLICATION

(11) **EP 0 987 800 A1**
(43) Date of publication of application: **22.03.2000**
(21) Application number: 99907857.9
(22) Date of filing: 03.03.1999
(51) Int. Cl.: H01S 3/18

(54) **SURFACE EMISSION LASER WITH MONITOR AND METHOD OF MANUFACTURING THE SAME**

(30) Priority: 11.03.1998 JP 6015598; 28.07.1998 JP 22762398
(71) Applicant: SEIKO EPSON CORPORATION, Suwa-shi, Nagano-ken (JP)
(72) Inventor: KITAMURA, Shojiro, Seiko Epson Corporation, Suwa-shi, Nagano-ken 392-8502 (JP); KAWASE, Takeo, Seiko Epson Corporation, Suwa-shi, Nagano-ken 392-8502 (JP); KANEKO, Takeo, Seiko Epson Corporation, Suwa-shi, Nagano-ken 392-8502 (JP)
(74) Representative: Hoffmann, Eckart, Dipl.-Ing.
(86) International application number: JP9901032
(87) International publication number: WO9946837

(57) **Abstract**

A surface emitting laser with a monitor which monitors the amount of emitted light by a peripheral part of a laser beam, emitted from an optical oscillator of a vertical cavity surface emitting laser (100A) in which an ohmic electrode (113) that has ohmic contact with a contact layer and a Schottky electrode (114) that has Schottky contact with the contact layer are formed, respectively. On a top of an electrode forming area (120), being incident to a depletion layer formed in a part where the Schottky electrode (114) contacts the contact layer (109), and detecting a photoelectric current generated in the depletion layer. In the surface emitting laser with a monitor, in an extremely simple structure, a vertical cavity surface emitting laser (100A) and a photodiode (100B) which monitors the amount of emitted light are monolithically formed.

## Description

### Technical Field

This invention relates to a surface emitting laser with a monitor which can monitor the amount of emitted light, and to a method of fabricating the same.

### Background Technology

Jpn. J. Appl. Phys. Vol. 35 (1996) pp. 506-507 discloses a device in which a photodiode which can monitor the amount of emitted light is monolithically formed with a vertical cavity surface emitting laser. This vertical cavity surface emitting laser has a PIN-type photodiode formed on a light emitting portion.

However, in the above-mentioned technology, in addition to a semiconductor layer which forms the vertical cavity surface emitting laser, it was necessary to further stack a plurality of semiconductor layers to structure the photodiode, and because of this, there was a problem such that the structure was complicated and the number of fabricating processes were numerous.

### Disclosure of the Invention

This invention solves the above-mentioned problems, and an object of this invention is to provide a surface emitting laser with a monitor with high capability with an extremely simple structure, and a method of fabricating the same.

A surface emitting laser with a monitor, wherein a body of stacked semiconductor layers including at least an active layer and a contact layer formed on one surface of a semiconductor substrate and a pair of electrode forming areas including an ohmic electrode to input current to the active layer are provided, and an optical cavity which emits a laser beam in a direction perpendicular to the semiconductor substrate is formed, and a Schottky barrier photodiode is provided in at least one of the pair of the electrode forming areas, in which a Schottky electrode is formed that has Schottky contact with a semiconductor layer that is in contact with the ohmic electrode and which can monitor a laser beam emitted from the optical cavity.

According to this surface emitting laser with a monitor, part of the laser beam emitted in the direction of the semiconductor substrate from the optical cavity is incident to a depletion layer of the Schottky barrier photodiode and detects a photoelectric current generated in the depletion layer, and can thereby monitor the amount of emitted light.

Furthermore, according to this surface emitting laser with a monitor, a Schottky barrier photodiode which monitors the amount of the emitted light of a vertical cavity surface emitting laser can be monolithically formed in an extremely simple structure. By so doing, the surface emitting laser with a monitor can extremely simplify APC (auto power control) which makes the amount of emitted light of the vertical cavity surface emitting laser constant.

The surface emitting laser with a monitor related to this invention described above can be obtained by a fabricating method including the following processes (a) and (b).

A method of fabricating a surface emitting laser with a monitor, includes a process (a) in which, on one surface of a semiconductor substrate, a body of stacked semiconductor layers including at least an active layer and a contact layer is formed and an optical cavity or a portion thereof that emits a laser beam in a direction perpendicular to the semiconductor substrate is obtained, and a process (b) in which, in at least one of a pair of electrode forming areas, an ohmic electrode to input current to the active layer and a Schottky electrode that has Schottky contact with a semiconductor layer that is in contact with the ohmic electrode are formed, and a Schottky barrier photodiode is obtained.

According to this fabricating method, a Schottky barrier photodiode can be monolithically formed in an extremely simple structure which forms a Schottky electrode along with an ohmic electrode in at least one of a pair of the electrode forming areas.

### Brief Description of the Drawings

- Fig. 1: is a cross-sectional view schematically showing a structure of a surface emitting laser with a monitor related to one embodiment of this invention.
- Fig. 2: is a plan view schematically showing a structure of the surface emitting laser with a monitor shown in Fig. 1, as seen from a side from which a laser beam is emitted.
- Fig. 3: is a circuit diagram schematically showing the surface emitting laser with a monitor shown in Figs. 1 and 2, and a circuit to drive the surface emitting laser with a monitor.
- Fig. 4: is a cross-sectional view schematically showing a structure of a surface emitting laser with a monitor related to another embodiment of this invention.
- Fig. 5: is a plan view schematically showing a structure of the surface emitting laser with a monitor shown in Fig. 4, as seen from a side opposite to a direction in which a laser beam is emitted.
- Fig. 6: is a circuit diagram schematically showing the surface emitting laser with a monitor shown in Figs. 4 and 5, and a circuit to drive the surface emitting laser with a monitor.

### Best Mode to Implement the Invention

A surface emitting laser with a monitor of this invention is a vertical cavity surface emitting laser which has a body of stacked semiconductor layers including at least an active layer and a contact layer formed on one surface of a semiconductor substrate, and a pair of electrode forming areas including an ohmic electrode to input current to the active layer. A characteristic point is that a Schottky barrier photodiode is provided in at least one of the pair of the electrode forming areas, in which a Schottky electrode is formed that has Schottky contact with a semiconductor layer that is in contact with the ohmic electrode and which can monitor a laser beam emitted from an optical cavity.

As a surface emitting laser with a monitor, the following two types of structures can be provided. First, in a surface emitting laser with a monitor of this invention, on a surface of the contact layer, a Schottky electrode that has Schottky contact with the contact layer and a first ohmic electrode that has ohmic contact with the contact layer are formed, respectively, and on another surface of the semiconductor substrate, a second ohmic electrode is formed that has ohmic contact with the semiconductor substrate, and a Schottky barrier photodiode is structured by the contact layer and the Schottky electrode.

In the surface emitting laser with a monitor of the first structure, if the wavelength of the laser beam is λ and the wavelength which is equivalent to the band gap energy of the contact layer is λ_{cont}, λ_{cont} ≥ λ is preferable. According to the surface emitting laser with a monitor, because part of the laser beam emitted from the optical oscillator is absorbed in the contact layer, it is possible to securely supply monitor light to the Schottky barrier photodiode.

In the surface emitting laser with a monitor of the first structure, the first ohmic electrode can be preferably used with the electrode of the Schottky barrier photodiode. According to the surface emitting laser with a monitor, an electrode forming area can be effectively utilized and a more simple structure can be used.

Additionally, it is preferable that the surface emitting laser with a monitor is structured by a plurality of electrode portions in which at least the first ohmic electrode is divided and the electrodes are symmetrically disposed, and in which the electrodes are formed in the electrode forming area. According to the surface emitting laser with a monitor, the supply of current to the active layer can be uniformly performed.

Second, in the surface emitting laser with a monitor of this invention, the stacked semiconductor layers also have a semiconductor layer which forms a Schottky barrier photodiode on one surface of the semiconductor substrate, on the surface of the contact layer, a first ohmic electrode is formed which has ohmic contact with the contact layer, on a surface of the semiconductor layer in which a predetermined area of the semiconductor substrate is removed and exposed, a Schottky electrode in Schottky contact with the semiconductor layer and a second ohmic electrode in ohmic contact with the semiconductor layer are formed, respectively, and the Schottky barrier photodiode is structured by the semiconductor layer and the Schottky electrode.

According to the surface emitting laser with a monitor of the second structure, part of the laser beam emitted in the direction of the semiconductor substrate from the optical cavity is incident to a depletion layer of the Schottky barrier photodiode and detects the photoelectric current generated in the depletion layer, and can thereby monitor the amount of emitted light. Furthermore, in this surface emitting laser with a monitor, being different from the surface emitting laser with a monitor of the first structure, because the contact layer can be formed by materials which do not absorb the wavelength of the emitted light, high output of the surface emitting laser is possible.

In this surface emitting laser with a monitor, the second ohmic electrode is preferably used as the electrode of the Schottky barrier photodiode. According to the surface emitting laser with a monitor, an electrode forming area can be effectively utilized and a more simple structure can be used.

Furthermore, in this surface emitting laser with a monitor, it is preferable that at least the second ohmic electrode is structured by a plurality of divided electrode portions and that the electrodes be symmetrically disposed on the surface of the semiconductor layer. According to this surface emitting laser with a monitor, supply of the current to the active layer can be more uniformly performed.

The surface emitting laser with a monitor related to this invention can be obtained by a method of fabricating this device including the above-mentioned processes (a) and (b).

Preferably, in the process (b), the surface emitting laser with a monitor of the first structure is fabricated by obtaining a Schottky barrier photodiode using a contact layer and a Schottky electrode, where on the surface of the contact layer which forms one electrode forming area, a Schottky electrode that has Schottky contact with the contact layer and a first ohmic electrode that has ohmic contact with the contact layer are formed, respectively. On another surface of the semiconductor substrate which forms another electrode forming area, a second ohmic electrode that has ohmic contact with the semiconductor substrate is formed.

Additionally, in the process (b), the surface emitting laser with a monitor of the second structure is preferably fabricated by obtaining a Schottky barrier photodiode using a semiconductor layer and a Schottky electrode, where in addition to process (a), a semiconductor layer for a Schottky barrier photodiode is further formed on the semiconductor substrate, and on the surface of the contact layer, a first ohmic electrode that has ohmic contact with the contact layer is formed. On the surface of the semiconductor layer in which a predetermined area of the semiconductor substrate is removed and exposed, a Schottky electrode that has Schottky contact with the semiconductor layer and a second ohmic electrode that has ohmic contact with the semiconductor layer are formed, respectively.

The following explains embodiments of this inventions with reference to the drawings.

### (Embodiment 1)

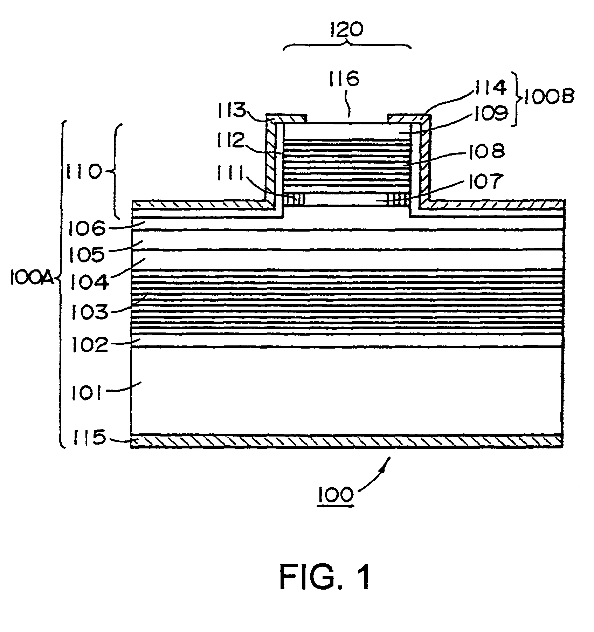

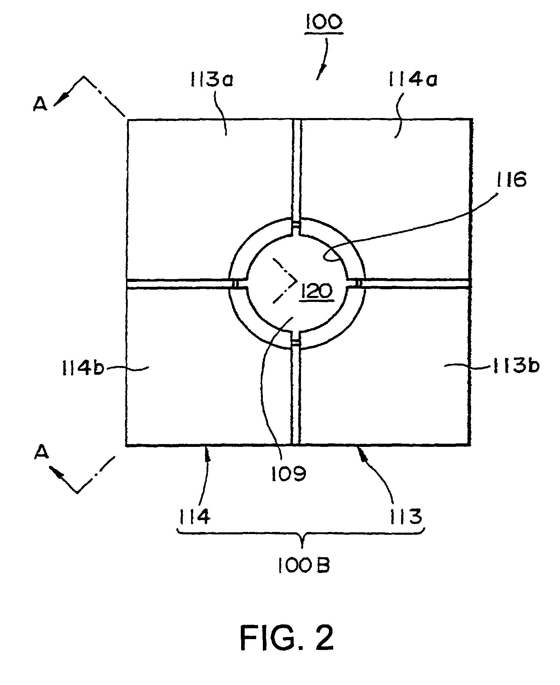

Fig. 1 is a cross-sectional view schematically showing a cross-sectional structure (cross section along line A-A of Fig. 2) of a surface emitting laser with a monitor 100 related to one embodiment of this invention. Fig. 2 is a plan view schematically showing a plan structure as seen from the side where the laser beam is emitted.

### (Structure of the Device)

A structure of the device of the surface emitting laser 100 with a monitor shown in Figs. 1 and 2 is explained. The surface emitting laser 100 is constituted by a buffer layer 102 formed of n-type GaAs, an n-type DBR mirror 103 with a structure of 30 pairs of alternately stacked n-type AlAs layers and n-type Al_{0.15}Ga_{0.85} layers, and having a reflectance of 99% or more for light in the vicinity of 800 nm, an n-type cladding layer 104 formed of n-type Al_{0.5}Ga_{0.5}As, an active layer 105 of a multi-quantum well structure formed of a GaAs well layer and an Al_{0.3}Ga_{0.7}As barrier layer, and in which there are five well layers, a p-type cladding layer 106 formed of p-type Al_{0.5}Ga_{0.5}As, a current aperture layer 107 formed of p-type AlAs, p-type DBR mirror 108 with a structure of 22 pairs of alternately stacked p-type AlAs layers and p-type Al_{0.15}Ga_{0.85} layers, and having a reflectance of 98.5% or more for light in the vicinity of 800 nm, and a contact layer 109 formed of p-type GaAs, all of which are sequentially stacked on a semiconductor substrate 101 formed of n-type AlAs.

Furthermore, from the contact layer 109 to the middle of the p-type cladding layer 106, the surface emitting laser 100 is etched in a circular shape as seen from the stacking direction, forming a column portion 110. In this embodiment, a plan shape of the column portion 110 is circular, but any arbitrary shape can be used.

Additionally, in order to concentrate the current from the p-type ohmic electrode 113, which will be described later, to only the center of the cavity, an insulating layer 111 formed of oxidized aluminum is formed in an area of approximately several µm at the circumference of the current aperture layer 107.

In addition, surrounding the column portion 110, an insulating layer 112 formed of a silicon oxide film (SiOₓ film) such as SiO₂ is formed.

On the top surface of the insulating layer 112 and the column portion 110, an upper electrode is formed. In this embodiment, the top surface of the column portion 110 is a first electrode forming area 120. Furthermore, in the center of the first electrode forming area 120, an open portion 116, which is an emitting port of a laser beam, is formed.

As shown in Fig. 2, the upper electrode which is formed on the top surface of the insulating layer 112 and the first electrode forming area 120 is divided into four electrode portions, and a p-type ohmic electrode 113 formed of metal such as chrome and gold-zinc alloy and a Schottky electrode 114 formed of metal such as gold are respectively formed. The p-type ohmic electrodes 113 is formed of two ohmic electrodes 113a and 113b which are diagonally disposed. The Schottky electrode 114 is formed of two Schottky electrodes 114a and 114b which are diagonally disposed.

Considering that current input to the active layer 105 is performed as uniformly as possible, it is preferable to dispose the p-type ohmic electrode 113 in a plane of the electrode forming area 120 symmetrically with respect to the center point.

Furthermore, with respect to the Schottky electrode 114, considering that the photoelectric current needed for monitoring of the amount of emitted light is obtained, the area of contact with the top surface of the contact layer 109 is ensured. These top electrodes are not limited to the shape shown in Fig. 2 and can have an arbitrary number of divisions and an arbitrary shape.

On the surface (second electrode forming area) opposite to the emitting direction of the laser beam of the semiconductor substrate 101, an n-type ohmic electrode 115 formed of metal such as gold-germanium alloy or the like is formed.

The vertical cavity surface emitting laser 100A is structured by semiconductor substrate 101, buffer layer 102, n-type DBR minor 103, n-type cladding layer 104, active layer 105, p-type cladding layer 106, current aperture layer 107, p-type DBR mirror 108, contact layer 109, p-type ohmic electrode 113, and n-type ohmic electrode 115. Additionally, by supplying current to the active layer 105 by using the p-type ohmic electrode 113 and the n-type ohmic electrode 115, a laser beam is emitted from the open portion 116.

Meanwhile, a Schottky barrier photodiode 100B is structured by Schottky electrode 114, contact layer 109, and p-type ohmic electrode 113. The p-type ohmic electrode 113 is a common electrode of the vertical cavity surface emitting laser 100A and the Schottky barrier photodiode 100B.

The laser beam emitted from the vertical cavity surface emitting laser 100A has the narrowest potion of the beam in the active layer 105 and as is it emitted from the open portion 116, it becomes wider at a predetermined radiation angle. At this time, when the peripheral part of the laser beam is incident to the portion that forms the Schottky barrier photodiode 100B, that is, a depletion region which is formed at a portion where the Schottky electrode 114 and the surface of the contact layer 109 are in contact, a photoelectric current is generated, and by detecting the current, the amount of light emitted by the vertical cavity surface emitting laser 100A can be monitored.

Furthermore, in order to effectively monitor the amount of light emitted by the vertical cavity surface emitting laser 100A using the Schottky barrier photodiode 100B, if the wavelength which is equivalent to the band gap energy of the contact layer 109 is λ_{cont} and the wavelength of the laser beam emitted from the vertically oscillating surface emitting laser 100A is λ, λ_{cont} ≥ λ is preferable. In this embodiment, in order to satisfy this relationship, the contact layer 109 is formed by p-type GaAs, but as long as the above-mentioned relationship is satisfied, it can also be formed by p-type AlGaAs.

### (Fabricating Method)

The following explains a method of fabricating a surface emitting laser with a monitor 100 related to this embodiment.
(1) First, on a semiconductor substrate 101 formed of n-type GaAs, a buffer layer 102 formed of n-type GaAs, an n-type DBR mirror 103 with a reflectance of 99% or more for the light in the vicinity of 800 nm, and formed of 30 pairs of an n-type AlAs layer and a n-type Al_{0.15}Ga_{0.85} layer, an n-type cladding layer 104 formed of n-type tAl_{0.5}Ga_{0.5}As, an active layer 105 of a multi-quantum well structure formed of a GaAs well layer and an Al_{0.3}Ga_{0.7}As barrier layer, and in which there are five well layers, a p-type cladding layer 106 formed of p-type Al_{0.5}Ga_{0.5}As, a current aperture layer 107 formed of p-type AlAs, a p-type DBR mirror 108 with a reflectance of 98.5% or more for light in the vicinity of 800 nm and formed of 22 pairs of a p-type AlAs layer and a p-type Al_{0.15}Ga_{0.85} layer, and the contact layer 109 formed of p-type GaAs are sequentially stacked.
   Each semiconductor layer which was mentioned above can be epitaxially grown by MOVPE (Metal-Organic Vapor Phase Epitaxy). Instead of the MOVPE method, an MBE (Molecular Beam Epitaxy) method or an LPE (Liquid Phase Epitaxy) method can be used.
(2) Next, after a photoresist is coated on the contact layer 109, the photoresist is patterned by photolithography, and a resist layer is formed in a predetermined pattern. Subsequently, using the resist layer as a mask, the contact layer 109, the upper DBR mirror 108, the current aperture layer 107, and halfway into the p-type cladding layer 106 are etched by reactive ion etching, and a column portion 110 is obtained.
   Next, by exposing the semiconductor layer 107 formed of AlAs in a vapor atmosphere at approximately 400°C for 1-30 minutes, the AlAs layer is oxidized from the exposed surface toward the inside, and oxidized aluminum, which is an insulator, is formed. By so doing, an insulator layer 111 formed of oxidized aluminum is formed surrounding the semiconductor layer formed of the AlAs at the center, and the current aperture layer 107 is formed.
(3) Next, using monosilane gas and oxygen gas, by a normal pressure heating CVD method which uses nitrogen gas as a carrier gas, a silicon oxide film is formed on the substrate. After that, by photolithography and dry etching, the silicon oxide film on the column portion 110 is etched and removed, and the insulating layer 112 is formed.
(4) Next, by a vacuum evaporation method, a metal layer formed of metal such as chrome and gold-zinc alloy or the like is formed on the semiconductor layer, and by photolithography and dry etching, a p-type ohmic electrode 113 with a predetermined pattern is formed on the surface of the insulating layer 112 and on the surface (first electrode forming area) of the top surface of column portion 110. Additionally, a Schottky electrode 114 formed of metal such as gold is formed with a predetermined pattern on the insulating layer 112 and the column portion 110 in the same manner. Furthermore, the order of forming the p-type ohmic electrode 113 and the Schottky electrode 114 is not limited.

Next, an n-type ohmic electrode 115 formed of metal such as gold-germanium alloy is formed on the lower surface (second electrode forming area) of the semiconductor substrate 101 by a vacuum evaporation method.

The structure of the surface emitting laser with a monitor 100 shown in Figs. 1 and 2 is formed via the above-mentioned process.

### (Driving Method)

The following explains one example of a method of driving the surface emitting laser with a monitor 100 related to embodiment 1.

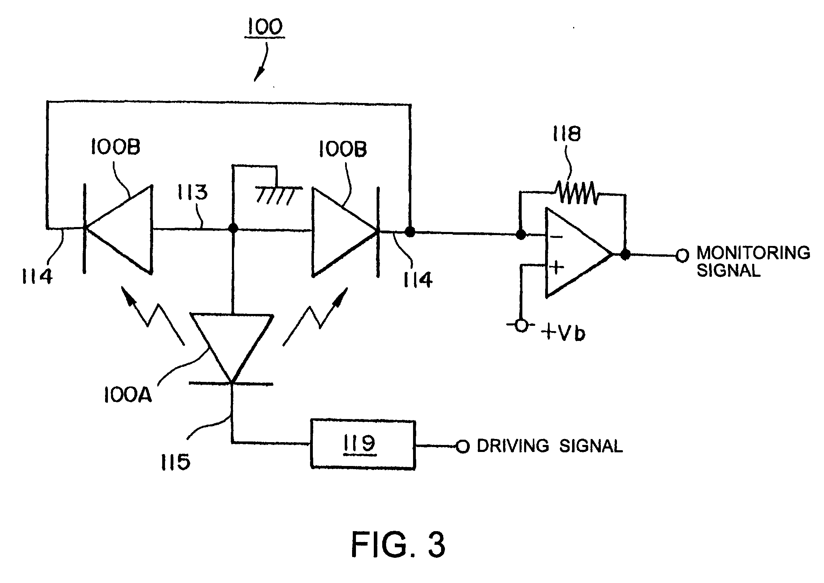

Fig. 3 is a schematic diagram showing a surface emitting laser 100 with a monitor, and a circuit to drive it. In Fig. 3, the p-type ohmic electrode 113 is grounded, and the Schottky electrode 114 and the n-type ohmic electrode 115 are connected to the current/voltage converting circuit 118 and the LD driving circuit 119, respectively.

The vertical cavity surface emitting laser 100A emits a laser beam with a light amount corresponding to a driving signal by the LD driving circuit 119.

Meanwhile, a photoelectric current generated in the Schottky barrier photodiode 100B by the emitted light from the vertical cavity surface emitting light laser 100A is output as a monitor signal by the current/voltage converting circuit 118. Using this monitor signal, by applying feedback to the LD driving circuit 119, auto power control (APC) can be performed, which makes the amount of emitted light constant.

Here, the current/voltage converting circuit 118 is biased at positive voltage Vb and the cathode of the Schottky barrier photodiode 100B (Schottky electrode 114) always has a higher electric potential than the anode (p-type ohmic electrode 113). Because of this, current to drive the vertical cavity surface emitting laser 100A does not flow into the Schottky barrier photodiode 100B, and only the photoelectric current generated by the emitted light from the vertical cavity surface emitting laser 100A is output as a monitor signal. Furthermore, by biasing the current/voltage/converting circuit 118 at a positive voltage, a reversed bias can be applied to the Schottky barrier photodiode 100B.

### (Embodiment 2)

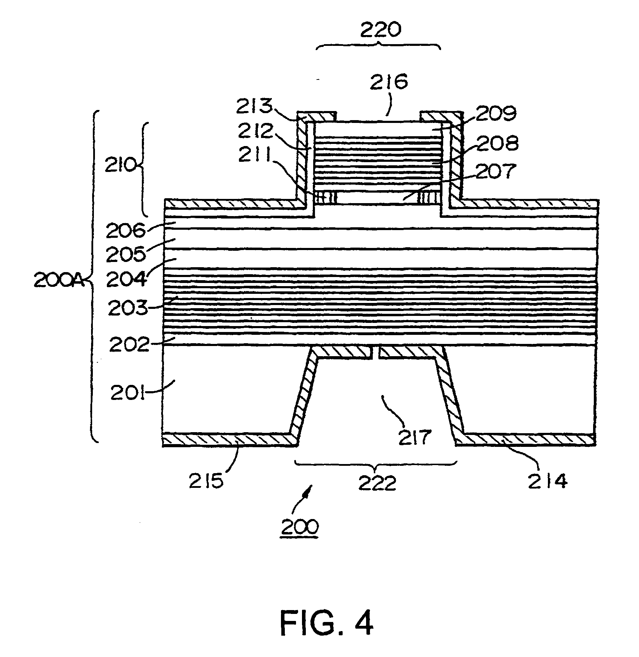

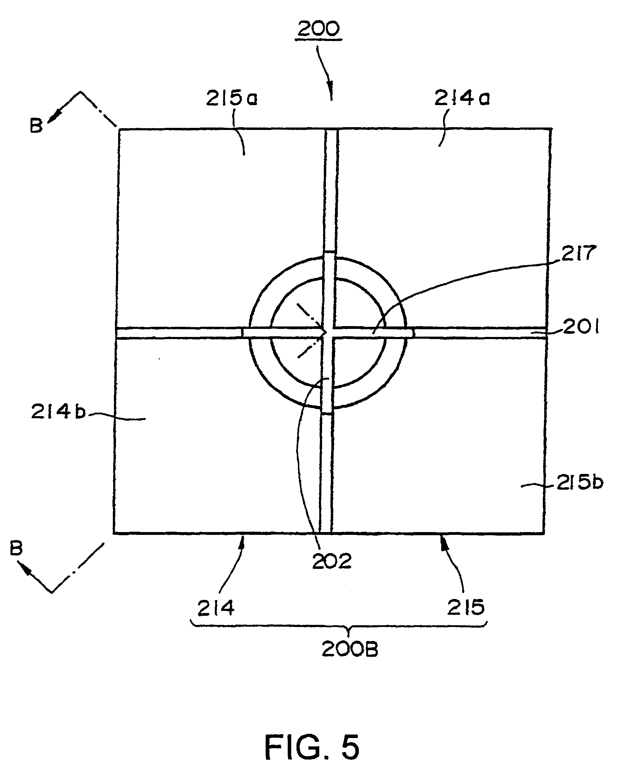

Fig. 4 is a cross-sectional view schematically showing a structure of a cross section (cross section along line B-B in Fig. 5) of a surface emitting laser 200 with a monitor related to another embodiment of this invention. Fig. 5 is a plan view schematically showing a structure of a plane seen from a side opposite to the direction where a laser beam is emitted.

### (Structure of the Device)

The structure of the device of the surface emitting laser 200 with a monitor shown in Figs. 4 and 5 is as follows. On a semiconductor substrate 201 formed of the n-type GaAs, a buffer layer 202 formed of n-type GaAs, an n-type DBR mirror 203 with a reflectance of 99% or more for light in the vicinity of 800 nm, and formed of 30 pairs of an n-type AlAs layer and a n-type Al_{0.15}Ga_{0.85} layer, an n-type cladding layer 204 formed of n-type Al_{0.5}Ga_{0.5}As, an activate layer 205 of a multi-quantum well structure formed of a GaAs well layer and an Al_{0.3}Ga_{0.7}As barrier layer, and in which there are five well layers, a p-type cladding layer 206 formed of p-type Al_{0.5}Ga_{0.5}As, a current aperture layer 207 formed of a p-type AlAs layer, a p-type DBR mirror 208 with a reflectance of 98.5% or more for light in the vicinity of 800 nm, and formed of 22 pairs of a p-type AlAs layer and a p-type Al_{0.15}Ga_{0.85} layer, and a contact layer 209 formed of p-type Al_{0.15}Ga_{0.85}As are sequentially stacked.

Furthermore, a column portion 210 which is etched in a circular shape as seen from a stacking direction is formed up to the middle of the p-type cladding layer 206. In this embodiment, a plan shape of the column portion 210 is circular, but the shape is not limited to this shape. An arbitrary shape can be used.

Additionally, in order to concentrate the current of the p-type ohmic electrode 213 to only the center of the cavity, the insulator layer 211 formed of oxidized aluminum is formed in the area of approximately several µm at the circumference of the current aperture layer 207.

Furthermore, surrounding the column portion 210, an insulating layer 212 formed of a silicon oxide film (SiOₓ film) such as SiO₂ is formed. On the surface (first electrode forming area 210) of the contact layer 209 and on the surface of the insulating layer 212, a p-type ohmic electrode 213 formed of metal such as chrome and gold-zinc alloy or the like is formed with a predetermined pattern. In addition, at the center of the top surface of the column portion 210, an open portion 216, which is an emitting port, is formed.

The semiconductor substrate 201 is etched until the buffer layer 202 is exposed from the rear side, and a hole part 217 is formed. Furthermore, as shown in Fig. 5, a Schottky electrode 214 formed of metal such as gold and an n-type ohmic electrode 215 formed of metal such as gold-germanium alloy or the like are respectively formed on a surface of the substrate 201 which is opposite to a direction in which a laser beam is emitted and in an area (second electrode forming area 222) in which the buffer layer 202 is exposed. The buffer layer 202 constitutes a semiconductor layer of the Schottky barrier photodiode 200B.

The vertical cavity surface emitting laser 200A is constituted by semiconductor substrate 201, buffer layer 202, n-type DBR mirror 203, n-type cladding layer 204, active layer 205, p-type cladding layer 206, current aperture layer 207, p-type DBR mirror 208, contact layer 209, p-type ohmic electrode 213, and n-type ohmic electrode 215. By supplying current to the active layer 205 using the p-type ohmic electrode 213 and the n-type ohmic electrode 215, a laser beam is emitted from the open portion 216.

Meanwhile, a Schottky barrier photodiode 200B is constituted by Schottky electrode 214, buffer layer 202, and n-type ohmic electrode 215. Furthermore, the n-type ohmic electrode 215 becomes a common electrode to the vertical cavity surface emitting laser 200A and the Schottky barrier photodiode 200B.

The laser beam is emitted from the open portion 216, but is also emitted in an opposite direction after going through the n-type DBR mirror 203. When the semiconductor substrate 201 is thick, light that has passed the n-type DBR mirror 203 is absorbed in the semiconductor substrate 201. Because of this, in this embodiment, a hole part 217 is disposed in the semiconductor substrate 201, and the transmitted light in the n-type DBR mirror 203 is incident to a depletion region formed in the part where the Schottky electrode 214 and the exposed surface of the buffer layer 202 are in contact. Because of this, the amount of light emitted by the vertical cavity surface emitting laser 200A can be monitored by the Schottky barrier photodiode 200B. In this embodiment, the hole part 217 is formed, but the entire semiconductor substrate 201 can be removed by etching.

Additionally, in this embodiment, being different from embodiment 1, the Schottky barrier photodiode 200B is formed by using the buffer layer 202, so the contact layer 209 can be formed by a material which does not absorb the wavelength of the emitted light. As a result, the vertical cavity surface emitting laser 200A can be high-output, compared to the vertical cavity surface emitting laser 100A of embodiment 1.

Furthermore, in this embodiment, the mirror on the laser beam emitting side can be constituted by a dielectric multi-layer film mirror formed of, for example, a SiOₓ layer and a TaOₓ layer. At this time, the dielectric multi-layer film mirror is stacked on the contact layer 209 and the p-type ohmic electrode 213.

### (Fabricating Method)

The method of fabricating the surface emitting laser 200 with a monitor related to this embodiment is basically the same as process (1), (2), and (3) in a method of fabricating the surface emitting laser 100 with a monitor in embodiment 1 described above, and the device can be manufactured, using the following (4') instead of process (4).

(4') A metal layer formed of metal such as chrome and gold-zinc alloy or the like is formed on the semiconductor layer by a vacuum evaporation method, and further, by photolithography and dry etching, a p-type ohmic electrode 213 with a predetermined pattern is formed on the surface (first electrode forming area 220) of the column portion 210 and on the surface of the insulating layer 212.

Next, the n-type ohmic electrode 215 formed of metal such as gold-germanium alloy or the like is formed on the lower surface (second electrode forming area 222) of the semiconductor substrate 201 using a vacuum evaporation method. In the same manner, the Schottky electrode 214 formed of metal such as gold with a predetermined pattern is formed. Furthermore, the order of forming the n-type ohmic electrode 215 and the Schottky electrode 214 is not limited.

The surface emitting laser 200 with a monitor shown in Figs. 4 and 5 is formed via the above-described process.

### (Driving Method)

The following explains one example of a method of driving a surface emitting laser 200 with a monitor in this embodiment.

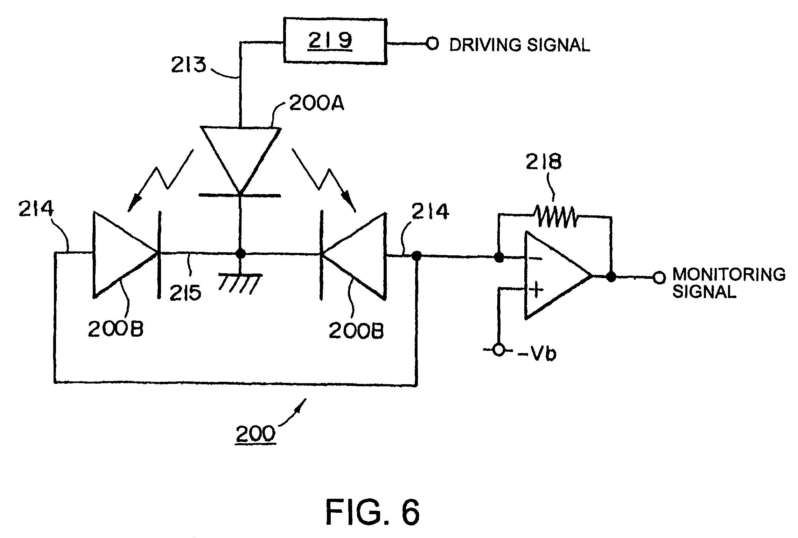

Fig. 6 is a diagram schematically showing a surface emitting laser 200 with a monitor and a circuit to drive it in this embodiment. In Fig. 6, n-type ohmic electrode 215 is grounded, and p-type ohmic electrode 213 and Schottky electrode 214 are connected to an LD driving circuit 219 and a current/voltage converting circuit 218, respectively.

The vertical cavity surface emitting laser 200A emits a laser beam with a light amount corresponding to a driving signal by the LD driving circuit 219.

Meanwhile, the photoelectric current generated in the Schottky barrier photodiode 200B by the emitted light from the vertical cavity surface emitting laser 200A is output as a monitor signal by the current/voltage converting circuit 218. By this monitor signal, by applying feedback to the LD driving circuit 219, auto power control (APC) which makes the amount of emitted light constant can be performed.

Here, because the n-type ohmic electrode 215 becomes a cathode electrode of the Schottky barrier photodiode 200B, this driving current does not flow into the Schottky barrier photodiode 200B, and only the photoelectric current generated by the emitted light from the vertical cavity surface emitting laser 200A is output as a monitor signal. Furthermore, the current/voltage converting circuit 218 is biased at negative voltage Vb and can apply reverse-bias to the Schottky barrier photodiode 200B.

As explained above, according to each surface emitting laser with a monitor related to embodiments of this invention, a Schottky barrier photodiode which monitors the amount of the emitted light of a vertical cavity surface emitting laser can be monolithically formed in an extremely simple structure with only little change to the structure of the conventional vertical cavity surface emitting laser. This type of surface emitting laser with a monitor can extremely simplify APC which makes the amount of emitted light of the vertical cavity surface emitting laser constant.

Furthermore, in the above-mentioned embodiments, even if p-type is replaced with n-type in each semiconductor layer, it is still within the scope of this invention. In the above-mentioned embodiment, the AlGaAs system is described, but other material systems can be used for semiconductor material according to the emitting wavelength. For example, the GalnP system, the ZnSSe system, and the InGaN system can be used. The above-described method of driving the surface emitting laser with a monitor is one example, and various changes can be done without departing from the scope of this invention. Additionally, in the above-mentioned embodiments, the column portions show one surface emitting laser with a monitor, but even if there are a plurality of column portions within the substrate, the embodiments of the invention do not suffer.

### Industrial Use of the Invention

A surface emitting laser of this invention performs APC of the amount of emitted light with an extremely simple structure and can be efficiently and stably driven, and can be applied to a variety of fields of an optical function device such as an optical disk, an optical communication light source, and the like.

The following explains the main symbols which are used in the drawings.
- 100, 200: Surface emitting lasers with a monitor
- 101, 201: Semiconductor substrates
- 102, 202: Buffer layers (etching stop layers)
- 103, 203: n-type DBR mirrors
- 104, 204: n-type cladding layers
- 105, 205: Active layers
- 106, 206: p-type cladding layers
- 107, 207: Current aperture layers
- 108, 208: p-type DBR mirrors
- 109, 209: Contact layers
- 110, 210: Column portions
- 112, 212: Insulating layers
- 113, 213: p-type ohmic electrodes
- 114, 214: Schottky electrodes
- 115, 215: n-type ohmic electrodes
- 116, 216: Open portions
- 217: Hole
- 118, 218: Current/voltage converting circuits
- 119, 219: LD driving circuits
- 120, 220, 222: Electrode forming areas

## Claims

1. A surface emitting laser with a monitor,
wherein a body of stacked semiconductor layers including at least an active layer and a contact layer formed on one surface of a semiconductor substrate and a pair of electrode forming areas including an ohmic electrode to input current to the active layer are provided, and an optical cavity which emits a laser beam in a direction perpendicular to the semiconductor substrate is formed, and
a Schottky barrier photodiode is provided in at least one of the pair of the electrode forming areas, in which a Schottky electrode is formed that has Schottky contact with a semiconductor layer that is in contact with the ohmic electrode and which can monitor a laser beam emitted from the optical cavity.

2. The surface emitting laser with a monitor as set forth in claim 1, wherein, on a surface of the contact layer, a Schottky electrode that has Schottky contact with the contact layer and a first ohmic electrode that has ohmic contact with the contact layer are formed, respectively, and on another surface of the semiconductor substrate, a second ohmic electrode is formed that has ohmic contact with the semiconductor substrate, and a Schottky barrier photodiode is formed by the contact layer and the Schottky electrode.

3. The surface emitting laser with a monitor as set forth in claim 2, wherein, when the wavelength of the laser beam is λ and the wavelength which is equivalent to the band gap energy of the contact layer is λ_{cont}, λ_{cont} ≥ λ.

4. The surface emitting laser with a monitor as set forth in claim 2 or 3, wherein the first ohmic electrode is used as one electrode of the Schottky barrier photodiode.

5. The surface emitting laser with a monitor as set forth in any of claims 2 through 4, wherein at least the first ohmic electrode is formed by a plurality of divided electrode portions and the electrode portions are symmetrically disposed in an electrode forming area in which the electrode portions are disposed.

6. The surface emitting laser with a monitor as set forth in claim 1,
wherein the stacked semiconductor layers also have a semiconductor layer which forms a Schottky barrier photodiode on one surface of the semiconductor substrate,
on the surface of the contact layer, a first ohmic electrode is formed which has ohmic contact with the contact layer,
on a surface of the semiconductor layer in which a predetermined area of the semiconductor substrate is removed and exposed, a Schottky electrode in Schottky contact with the semiconductor layer and a second ohmic electrode in ohmic contact with the semiconductor layer are formed, respectively, and
the Schottky barrier photodiode is formed by the semiconductor layer and the Schottky electrode.

7. The surface emitting laser with a monitor as set forth in claim 6, wherein the second ohmic electrode is used as the electrode of one Schottky barrier photodiode.

8. The surface emitting laser with a monitor as set forth in claim 6 or 7, wherein at least the second ohmic electrode is formed by a plurality of divided electrode portions and the electrode portions are symmetrically disposed on a surface of the semiconductor layer.

9. A method of fabricating a surface emitting laser with a monitor, comprising:
a process (a) in which, on one surface of a semiconductor substrate, stacked semiconductor layers including at least an active layer and a contact layer is formed and an optical cavity or a portion thereof that emits a laser beam in a direction perpendicular to the semiconductor substrate is obtained, and
a process (b) in which, in at least one of a pair of electrode forming areas, an ohmic electrode to input current to the active layer and a Schottky electrode that has Schottky contact with a semiconductor layer that is in contact with the ohmic electrode are formed, and a Schottky barrier photodiode is obtained.

10. The method of fabricating a surface emitting laser with a monitor as set forth in claim 9,
wherein, in the process (b), on the surface of the contact layer which forms one electrode forming area, a Schottky electrode that has Schottky contact with the contact layer and a first ohmic electrode that has ohmic contact with the contact layer are formed, respectively, and
on another surface of the semiconductor substrate which forms another electrode forming area, a second ohmic electrode that has ohmic contact with the semiconductor substrate is formed, by which a Schottky barrier photodiode is obtained by the contact layer and the Schottky electrode.

11. The method of fabricating a surface emitting laser with a monitor as set forth in claim 10, wherein, in the process (a), when the wavelength of the laser beam is λ, if a wavelength which is equivalent to the band gap energy of the contact layer is λ_{cont}, the contact layer is formed by a semiconductor in which the relationship of λ_{cont} ≥ λ is established.

12. The method of fabricating a surface emitting laser with a monitor as set forth in claim 10, wherein at least the first ohmic electrode is formed as a plurality of divided electrode portions and the electrode portions are symmetrically disposed in the electrode forming area.

13. The method of fabricating a surface emitting laser with a monitor as set forth in claim 9,
wherein, in the process (a), a semiconductor layer for a Schottky barrier photodiode is further formed on the semiconductor substrate, and
in the process (b), on the surface of the contact layer, a first ohmic electrode that has ohmic contact with the contact layer is formed, and on the surface of the semiconductor layer in which a predetermined area of the semiconductor substrate is removed and exposed, a Schottky electrode that has Schottky contact with the semiconductor layer and a second ohmic electrode that has ohmic contact with the semiconductor layer are formed, respectively, whereby a Schottky barrier photodiode is obtained by the semiconductor layer and the Schottky electrode.

14. The method of fabricating a surface emitting laser with a monitor as set forth in claim 13, wherein at least the second ohmic electrode is formed as a plurality of divided electrode portions and the electrode portions are symmetrically disposed on the semiconductor layer.
